# EUROPEAN PATENT APPLICATION

(11) **EP 4 575 783 A1**
(43) Date of publication of application: **25.06.2025**
(21) Application number: 23869960.7
(22) Date of filing: 28.07.2023
(51) Int. Cl.: G06F 9/50

(54) **DYNAMIC MEMORY FREQUENCY REDUCTION METHOD FOR AIR CONDITIONER, AIR CONDITIONER, AND STORAGE MEDIUM**

(30) Priority: 30.09.2022 CN 202211216995
(71) Applicant: GD Midea Air-Conditioning Equipment Co., Ltd., Foshan, Guangdong 528311 (CN)
(72) Inventor: HUO, Weiming, Foshan, Guangdong 528311 (CN)
(74) Representative: RGTH
(86) International application number: PCT/CN2023/109958
(87) International publication number: WO 2024/066714

(57) **Abstract**

The present application discloses a method for dynamically reducing a memory frequency of an air conditioner, an air conditioner and a computer-readable storage medium. The method includes: determining a current interference value of the air conditioner during operation of the air conditioner; determining a target memory frequency corresponding to the current interference value according to the determined current interference value; and updating the current memory frequency of the air conditioner according to the target memory frequency.

## Description

This application claims priority to Chinese Patent Application No. 202211216995.6, filed on September 30, 2022, the entire content of which are incorporated herein by reference.

### TECHNICAL FIELD

The present application relates to the technical field of air conditioning, and in particular to a method for dynamically reducing a memory frequency of an air conditioner, an air conditioner and a storage medium.

### BACKGROUND

The wire controller in the air conditioning system often refers to the controller that controls the start and stop, mode, temperature, wind speed and other settings of the air conditioner. It is characterized by its wired connection to the air conditioner indoor unit. Existing wire controllers often contain internal memory, that is, memory. Due to the various electromagnetic interferences in the environment where the air conditioner is located, such as the different electromagnetic interferences generated by the compressor and motor during operation, it is easy to affect the access of memory data in the internal memory, thereby causing abnormal control of the air conditioner, seriously affecting the user experience.

### SUMMARY

### TECHNICAL PROBLEM

The main purpose of the present application is to provide a method for dynamically reducing a memory frequency of an air conditioner, an air conditioner and a computer-readable storage medium, aiming to solve the technical problem that control abnormality of the air conditioner is easily caused by electromagnetic interference in the environment where the air conditioner is located.

### TECHNICAL SOLUTION

To achieve the above purpose, the present application provides a method for dynamically reducing a memory frequency, including:
determining a current interference value of the air conditioner during operation of the air conditioner;
determining a target memory frequency corresponding to the current interference value according to the determined current interference value; and
updating a current memory frequency of the air conditioner according to the target memory frequency.

In an embodiment, the determining the current interference value of the air conditioner during the operation of the air conditioner includes:
obtaining a current preset operating parameter during the operation of the air conditioner; and
calculating or looking up a table to obtain the current interference value of the air conditioner according to the obtained preset operating parameter.

In an embodiment, the determining the current interference value of the air conditioner during the operation of the air conditioner includes:
determining the current interference value of the air conditioner at a preset interval duration during the operation of the air conditioner; or
determining the current interference value of the air conditioner in response to that a parameter setting operation is received or a working state of the air conditioner changes during the operation of the air conditioner.

In an embodiment, the determining the target memory frequency corresponding to the current interference value according to the determined current interference value includes:
determining a target interference level of the current interference value according to a preset interference level; and
determining the target memory frequency corresponding to the target interference level.

In an embodiment, the method for dynamically reducing the memory frequency further includes:
determining a current operating function of the air conditioner; and
in response to that the current operating function is a personal safety function, determining a step of the target memory frequency corresponding to the current interference value according to the determined current interference value.

In an embodiment, the method for dynamically reducing the memory frequency further includes:
in response to that the current operating function is the personal safety function, detecting whether a parameter setting operation is received;
in response to that the parameter setting operation is received, generating a prompt to enter a preset safety mode; and
in response to receiving a confirmation to enter the preset safety mode, determining the step of the target memory frequency corresponding to the current interference value according to the determined current interference value.

In an embodiment, after the determining the current operating function of the air conditioner, the method further includes:
in response to the current operating function is a non-personnel safety function, determining a current memory frequency corresponding to a current compressor frequency of the air conditioner, and determining a target memory frequency corresponding to the current interference value according to the determined current interference value; and
selecting a lower memory frequency between the current memory frequency and the target memory frequency as the current memory frequency.

In an embodiment, after the determining the target memory frequency corresponding to the current interference value according to the determined current interference value, the method further includes:
configuring the target memory frequency as a target memory frequency of other air conditioner indoor units connected to a same outdoor unit.

Besides, in order to achieve the above objective, the present application further provides a device for dynamically reducing a memory frequency, including an interference identification module and a memory adjustment module.

The interference identification module is configured to determine the current interference value of the air conditioner during the operation of the air conditioner.

The memory adjustment module is configured to determine the target memory frequency corresponding to the current interference value according to the determined current interference value; and update the current memory frequency of the air conditioner according to the target memory frequency.

Besides, in order to achieve the above objective, the present application further provides an air conditioner, including a processor, a memory, and a program for dynamically reducing a memory frequency stored in the memory and executable by the processor, wherein when the program for dynamically reducing the memory frequency is executed by the processor, the method for dynamically reducing the memory frequency as described above is implemented.

The present application further provides a computer-readable storage medium, wherein a program for dynamically reducing a memory frequency is stored on a computer-readable storage medium, when the program for dynamically reducing the memory frequency is executed by a processor, the method for dynamically reducing the memory frequency as described above is implemented.

### TECHNICAL EFFECT

The method for dynamically reducing the memory frequency in the technical solution of the present application includes the following steps: during the operation of the air conditioner, determining the current interference value of the air conditioner; according to the determined current interference value, determining the target memory frequency corresponding to the current interference value; and according to the target memory frequency, updating the current memory frequency of the air conditioner. The present application solves the technical problem that the abnormal control of the air conditioner is easily caused by the electromagnetic interference in the environment where the air conditioner is located.

At its core, the present application mainly determines the current interference value of the environment in which the air conditioner is located during the operation of the air conditioner, and determines the target memory frequency between the air conditioner and the wire controller according to the current interference value. This enables the air conditioner to dynamically adjust the memory frequency of the internal memory in the air conditioner under different electromagnetic interference environments. By dynamically reducing the memory frequency in a relatively strong electromagnetic interference environment, the stability of the memory data can be ensured, thereby ensuring the accuracy and reliability of the control of the air conditioner by the wire controller or the central control panel, preventing electromagnetic interference from damaging the data in the internal memory, and avoiding damage to the air conditioner caused by the influence of electromagnetic interference on the memory data. At the same time, the air conditioner can operate normally and as expected under the control of the wire controller or the central control panel, thereby ensuring the comfort of the indoor environment and improving the user experience.

### BRIEF DESCRIPTION OF THE DRAWINGS

FIG. 1 is a schematic structural diagram of a hardware operating environment of an air conditioner involved in an embodiment of the present application.
FIG. 2 is a flow chart of a method for dynamically reducing a memory frequency according to an embodiment of the present application.
FIG. 3 is a detailed flow chart of step S10 in the method for dynamically reducing the memory frequency according to an embodiment of the present application.
FIG. 4 is a detailed flow chart of step S20 in the method for dynamically reducing the memory frequency according to an embodiment of the present application.
FIG. 5 is a flow chart of the method for dynamically reducing the memory frequency according to an embodiment of the present application.
FIG. 6 is an overall application flow chart of the method for dynamically reducing the memory frequency according to an embodiment of the present application.
FIG. 7 is a schematic diagram of a multi-terminal connection relationship of the air conditioner involved in an internal communication control method for the air conditioner according to the present application.
FIG. 8 is a schematic structural diagram of a framework of a device for dynamically reducing the memory frequency according to the present application.

The realization of the purpose, functional features and advantages of the present application will be further described in conjunction with the embodiments, with reference to the accompanying drawings.

### DETAILED DESCRIPTION OF EMBODIMENTS

It should be understood that the specific embodiments described here are only used to explain the present application and are not used to limit the present application.

The present application mainly determines the electromagnetic interference status of the environment where the air conditioner is located accurately, and to prevent the electromagnetic interference from affecting the memory data in the wire controller or the central control panel, determines the target memory frequency of the corresponding air conditioner according to different interference values, and finally updates the original memory frequency to the determined target memory frequency, so that the internal memory in the air conditioner can maintain the stability of the memory data. Consequently, the wire controller or the central control panel can control the air conditioner more stably and accurately according to the memory data. The core of the present application is to dynamically reduce the frequency of the internal memory according to the prediction of the electromagnetic interference in the environment where the air conditioner is located, to ensure the stability of the memory data in the air conditioner, thereby ensuring the stability and reliability of the air conditioner control.

The embodiment of the present application proposes an air conditioner.

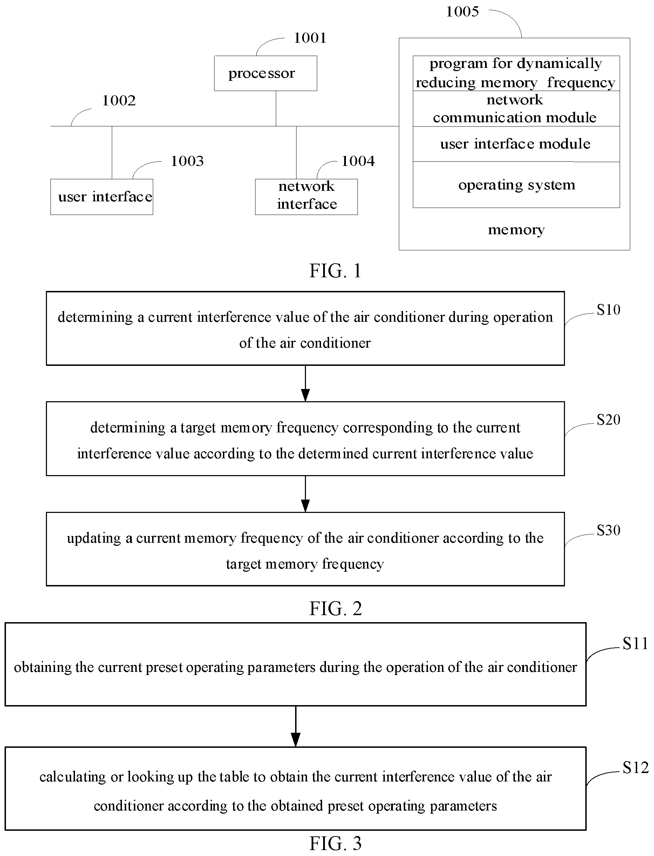

As shown in FIG. 1, FIG. 1 is a schematic structural diagram of a hardware operating environment of an air conditioner involved in an embodiment of the present application.

As shown in FIG. 1, the air conditioner can include: a processor 1001, such as a central processing unit (CPU), a communication bus 1002, a user interface 1003, a network interface 1004, and a memory 1005. The communication bus 1002 is configured to implement connection communication between these components. The user interface 1003 can include a display screen (display) and an input unit such as a control panel. The user interface 1003 can also include a standard wired interface and a wireless interface. The network interface 1004 can include a standard wired interface and a wireless interface (such as a Wi-Fi interface). The memory 1005 can be a high-speed random access memory (RAM), or a stable non-volatile memory (NVM), such as a disk memory. The memory 1005 can also be a storage device independent of the aforementioned processor 1001.

Those skilled in the art can understand that the hardware structure shown in FIG. 1 does not constitute a limitation on the device, and can include more or less components than shown, or combinations of certain components, or components arranged differently.

As shown in FIG. 1, the memory 1005 as a computer readable storage medium in FIG. 1 can include an operating system, a network communication module, and a memory dynamic frequency reduction program.

In FIG. 1, the network communication module is mainly used to connect to a server and communicate data with the server. The processor 1001 can call the memory dynamic frequency reduction program stored in the memory 1005 and execute the steps in the following embodiments.

Based on the hardware structure of the above controller, various embodiments of the method for dynamically reducing the memory frequency of the present application are proposed.

The present application provides a method for dynamically reducing the memory frequency.

Please refer to FIG. 2, which is a flow chart of the method for dynamically reducing the memory frequency according to an embodiment of the present application. In an embodiment of the present application, the method for dynamically reducing the memory frequency includes the following steps.

Step S10, determining a current interference value of the air conditioner during operation of the air conditioner.

In an embodiment, the internal communication control method of the air conditioner is applied to a wire controller or a central control panel. The wire controller refers to a device capable of controlling the air conditioner at home, and is characterized by its wired connection to the air conditioner indoor unit. The wire connection can be a two-core non-polarity, 485, etc. air conditioner control terminal. Another feature of the wire controller is that it is equipped with an operating system, a touch screen, a voice recognition module and other features. The touch screen includes but is not limited to liquid crystal display (LCD) and organic light-emitting diode (OLED) display. The central control panel refers to a control terminal that has the ability to control the wire controller and also has the ability to manage, control and display the status of home smart devices. The central control panel is also connected to the air conditioner in a wired manner like the wire controller. The central control panel is also equipped with an operating system, and also includes features such as a touch screen and a voice recognition module.

Since the central control panel has all the functions of the wire controller, the central control panel can also be regarded as a wire controller. For the convenience of description, the wire controller is used to refer to the wire controller and the central control panel in the general sense.

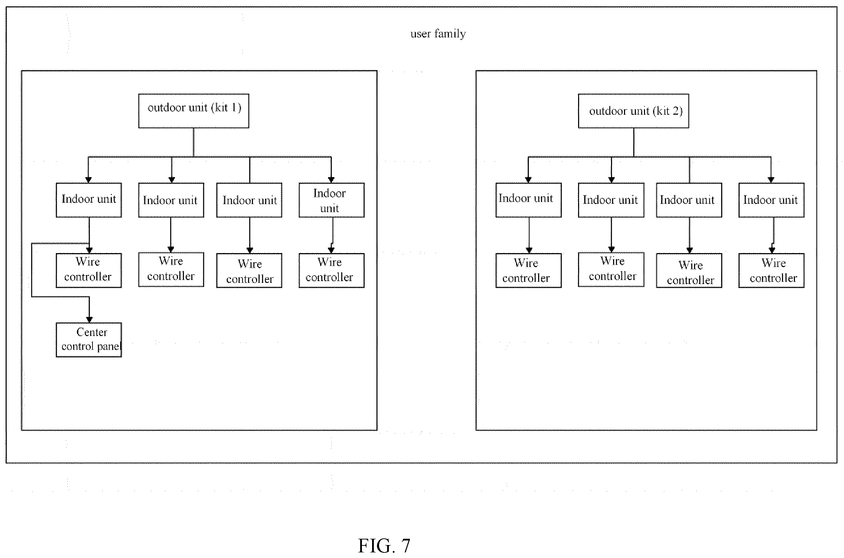

As for the specific connection relationship of the wire controller in the air conditioner, it is mainly connected to the indoor unit of the air conditioner for communication. For the connection relationship between the two, referring to FIG. 7, which is a schematic diagram of the multi-terminal connection relationship of the air conditioner involved in the internal communication control method of the air conditioner according to the present application. As shown in FIG. 7, taking kit 1 as an example, the outdoor unit is communicated with the indoor unit, and the wire controller is communicated with the indoor unit. In addition, if there is a central control panel, it is also communicated with the indoor unit. In addition, according to actual needs, the wire controller can also be communicated with the outdoor unit so that the user can directly monitor or control the operation of the outdoor unit indoors, which is not limited here.

During the operation of the air conditioner in cooling, heating, defrosting, fresh air and other modes or functions, it is necessary to determine the electromagnetic interference in the environment where the air conditioner is located, and digitize the electromagnetic interference into the current interference value to accurately grasp the interference degree of the electromagnetic interference. It should be noted that the electromagnetic interference here is caused by various reasons, such as the interference generated by various motors including various fans in the air conditioner during operation, the electromagnetic interference generated by the operation of the compressor and the operation of other equipment in the air conditioner. In addition to the interference caused by the operation of the air conditioner itself to the wire controller, the reasons also include the electromagnetic interference generated by the operation of other adjacent or nearby air conditioners. For example, if the air conditioner kit 2 in FIG. 7 is adjacent to the kit 1, the electromagnetic interference will be generated between them. In addition to this, there are various other external electromagnetic interferences, which are not listed here.

In an environment with electromagnetic interference, various operating data signals from the air conditioner indoor unit (which can also be the air conditioner outdoor unit, here only the air conditioner indoor unit is used for explanation) received by the wire controller and various control signals output to the air conditioner indoor unit will be interfered. In other words, the wire controller's control of the air conditioner's indoor unit is interfered, resulting in abnormal control of the air conditioner by the wire controller.

How to determine the current interference value of the air conditioner can be determined by looking up a table or calculating according to various operating parameters of the air conditioner. The operating parameters here include but are not limited to: set temperature, set wind speed, operation mode (cooling, heating, fresh air, defrosting, energy saving, etc.), indoor fan gear or speed, outdoor fan gear or speed, air outlet temperature, indoor temperature, indoor humidity, outdoor heat exchanger temperature, indoor heat exchanger temperature, compressor temperature, compressor frequency, etc.

Please refer to FIG. 3, in an embodiment, step S10 includes:
step S11, obtaining the current preset operating parameters during the operation of the air conditioner; and
step S12, calculating or looking up the table to obtain the current interference value of the air conditioner according to the obtained preset operating parameters.

In an embodiment, the preset operating parameters can be the above-mentioned various working condition parameters, and the preset operating parameters can be divided into two categories: user-set parameters and air conditioner self-adjustment parameters. The user-set parameters can include operating parameters such as set temperature, set wind speed, and operating mode, and the air conditioner self-adjustment parameters can include operating parameters such as indoor fan gear or speed, outdoor fan gear or speed, air outlet temperature, indoor temperature, indoor humidity, outdoor heat exchanger temperature, indoor heat exchanger temperature, compressor temperature, compressor frequency, etc. The difference between the user-set parameters and the air conditioner self-adjustment parameters lies in whether the operating parameters are parameters set by the user or operating parameters required for the air conditioner to perform adaptive adjustment.

After the current preset operating parameters are determined, the current interference value of the air conditioner can be calculated by using one or more of the preset operating parameters. For the calculation method, the preset operating parameters can be input into the preset interference calculation function to accurately obtain the current interference value. The current interference value can also be obtained by determining the mapping relationship between one or more preset operating parameters and the current interference value and looking up the table. It should be noted that both the function required for calculation and the table required to be queried are determined based on a large number of experiments. In addition, the corresponding target mapping table can be determined first according to the parameter type of the preset operating parameters (user-set parameters and air-conditioner self-adjusting parameters), and then the current interference value of the air conditioner can be determined by looking up different target mapping tables respectively, to specifically distinguish different types of operating parameters and determine different current interference values. Different processing can be performed according to whether there is a user operating the wire controller to set each user-set parameter, thereby satisfying the memory frequency control in different scenarios and reducing unnecessary troubles to the user.

In an embodiment, step S12, calculating the current interference value of the air conditioner according to the obtained preset operating parameters includes:
step a, detecting the input signal of the wire controller corresponding to the preset operating parameters, and determining the actual signal amplitude of the input signal and the predicted signal amplitude corresponding to the preset operating parameters; and
step b, calculating the difference between the actual signal amplitude and the predicted signal amplitude to determine the current interference value of the air conditioner.

Different preset operating parameters will generate different input signals. In other words, the input signal input into the wire controller varies with the various operating parameters of the air conditioner. The operating parameters here include not only the number of operating parameters, but also the specific working condition values of the operating parameters. Detecting the input signal of the wire controller corresponding to the preset operating parameters is to detect the signal actually input into the wire controller, determine the actual signal amplitude of the input signal, and also determine the predicted signal amplitude corresponding to the preset operating parameters. The predicted signal amplitude corresponding to the preset operating parameters refers to the signal amplitude of the input signal corresponding to the preset operating parameters in an environment without electromagnetic interference, which can also be considered as the theoretical signal amplitude of the theoretical input signal.

In an environment with electromagnetic interference, the actual signal amplitude is greater than the predicted signal amplitude. The difference between the actual signal amplitude and the predicted signal amplitude is obtained by subtracting the actual signal amplitude from the predicted signal amplitude. This difference can be used as the current interference value of the air conditioner to more accurately and reliably reflect the impact of electromagnetic interference on the wire controller. The greater the difference, the larger the actual signal amplitude is compared to the predicted signal amplitude, which essentially reflects the greater the degree of electromagnetic interference.

In an embodiment, the step S10 includes:
step c, during the operation of the air conditioner, determining the current interference value of the air conditioner at a preset interval duration; or
step d, during the operation of the air conditioner, when a parameter setting operation is received or the working state of the air conditioner changes, determining the current interference value of the air conditioner.

During the operation of the air conditioner, the current interference value of the air conditioner can be obtained and determined by the air conditioner in real time, or the current interference value of the air conditioner can be determined at the preset interval duration, so that the electromagnetic interference status of the environment where the air conditioner is located can be grasped in a timely manner. The preset interval duration can be set according to actual needs, such as 1 minute, 2 minutes, etc., which is not limited here.

During the operation of the air conditioner, when the wired controller receives the parameter setting operation performed by the user, that is, when the user uses the wired controller to control the air conditioner, it is possible to start acquiring and determining the current interference value of the air conditioner, or when the working state of the air conditioner changes, it is possible to start acquiring and determining the current interference value of the air conditioner. Here, the working state of the air conditioner is considered to have changed when the change in any preset operating parameter is greater than its corresponding preset change threshold. In this case, it can be considered that the working state has changed. For example, the cooling temperature is 27°C at the beginning and then changes to 22°C. The preset change threshold is 4°C, then it is considered that the working state has changed. The change in the working state of the air conditioner can also be understood as a change in the operating mode, such as the conversion of the fresh air mode to the cooling mode. Considering that the electromagnetic interference of the air conditioner usually changes only when various working conditions change through parameter setting operations or the working state of the air conditioner changes, it is only by determining the current interference value of the air conditioner when the working conditions change that electric energy can be saved, and the current interference value is determined in time when the working conditions change to make corresponding memory frequency processing.

Step S20, determining the target memory frequency corresponding to the current interference value according to the determined current interference value.

According to the current interference value, the target memory frequency can be directly determined according to the corresponding relationship between the interference value and the memory frequency, or the target interference level corresponding to the current interference value can be determined first, and then the target memory frequency corresponding to the current interference value can be determined according to the target interference level. The memory frequency refers to the data throughput per second of the internal memory, and the internal memory can be embedded multi media card (EMMC, embedded memory).

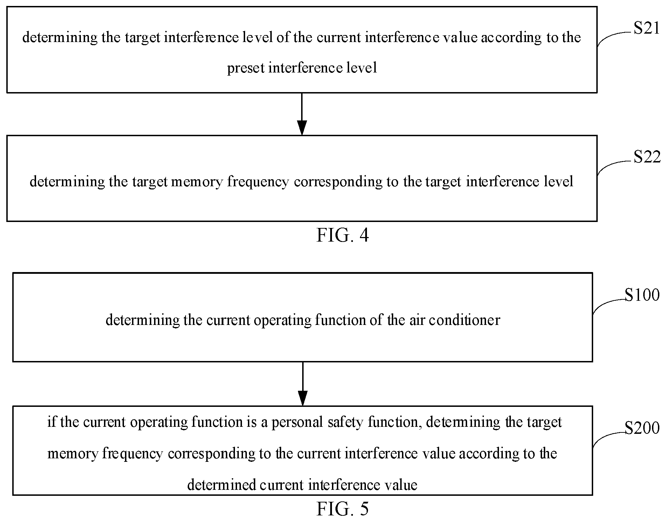

Please refer to FIG. 4, in an embodiment, the step S20 includes:
step S21, determining the target interference level of the current interference value according to the preset interference level; and
step S22, determining the target memory frequency corresponding to the target interference level.

Multiple preset interference levels can be set, depending on actual needs, such as setting three interference levels P1, P2 and P3. Different interference levels correspond to different interference value ranges. For example, assuming that the interference value range of P1 is [10, 300) and the interference value range of P2 is [30, 50). Under the preset interference level rules, the target interference level corresponding to the current interference value can be determined. For example, if the current interference value is 40, the target interference level is P2. Different interference levels also correspond to different memory frequencies. The interference value can be proportional to the interference level, and the interference level is inversely proportional to the memory frequency. That is to say, the larger the current interference value and the higher the interference level, the smaller the target memory frequency between the corresponding wire controller and the air conditioner room. Therefore, when the electromagnetic interference is stronger, the memory frequency of the internal memory in the wire controller is reduced, thereby ensuring the stability of the memory data, so that the wire controller can accurately and reliably control the air conditioner. In addition, by first determining the interference level and then determining the target memory frequency based on the interference level, one purpose is to save air-conditioning system resources, and the other is to prevent the instability of the memory frequency caused by slight changes in the interference value from causing unnecessary trouble to the user and affecting the user's use of the air conditioner.

In an embodiment, before step S20, the method further includes:
step e, determining whether the determined current interference value has changed from the last determined interference value; and
step f, if the determined current interference value has changed from the last determined interference value, determining the target memory frequency corresponding to the current interference value according to the determined current interference value.

Before determining the target memory frequency, it is possible to first determine whether the current interference value has changed from the last determined interference value. Only when the current interference value has changed will the target memory frequency be further determined and the internal memory in the wire controller will access data according to the target memory frequency, thereby avoiding the air-conditioning system constantly updating the same target memory frequency according to the original interference value, thereby increasing the load of the air-conditioning system. If the current interference value has not changed, it is only necessary to access data according to the original target memory frequency, and there is no need to proceed to the next step. However, if the current interference value changes, the following steps S20 and S30 need to be performed, so that a new target memory frequency can be re-determined to achieve dynamic adjustment of the memory frequency.

Step S30, updating the current memory frequency of the air conditioner according to the target memory frequency.

After the target memory frequency is determined, the memory frequency in the original internal memory is updated to the target memory frequency. Thereafter, unless the current interference value changes, data such as the operating conditions of air-conditioning-related equipment can be accessed according to the current target memory frequency.

The present application mainly determines the current interference value of the environment in which the air conditioner is located during the operation of the air conditioner, and determines the target memory frequency between the air conditioner and the wire controller according to the current interference value. This enables the air conditioner to dynamically adjust the memory frequency of the internal memory in the air conditioner under different electromagnetic interference environments. By dynamically reducing the memory frequency in a relatively strong electromagnetic interference environment, the stability of the memory data can be ensured, thereby ensuring the accuracy and reliability of the control of the air conditioner by the wire controller or the central control panel, preventing electromagnetic interference from damaging the data in the internal memory, and avoiding damage to the air conditioner caused by the influence of electromagnetic interference on the memory data. At the same time, the air conditioner can operate normally and as expected under the control of the wire controller or the central control panel, thereby ensuring the comfort of the indoor environment and improving the user experience.

Please refer to FIG. 5, which is a flow chart of the method for dynamically reducing the memory frequency according to an embodiment of the present application. Further, based on the method for dynamically reducing the memory frequency according to an embodiment of the present application, an embodiment of the method for dynamically reducing the memory frequency of the present application is proposed. In an embodiment, the method for dynamically reducing the memory frequency also includes:
step S100, determining the current operating function of the air conditioner; and
step S200, if the current operating function is a personal safety function, determining the step of the target memory frequency corresponding to the current interference value according to the determined current interference value.

In an embodiment, the current operating function of the air conditioner includes but is not limited to one or a combination of cooling, heating, fresh air, strong wind, swing wind, dehumidification, noise reduction, defrosting, sleep and other functions. Functions such as heating, fresh air, defrosting, and cooling under extreme outdoor high temperatures can be used as personal safety functions, and other functions can also be used as personal safety functions, without restriction. The so-called personal safety function here means that the lack of the corresponding function of the air conditioner will affect human health and body functions. It is easier to understand that, for example, in the cold winter, air conditioning heating is an indispensable way for users to keep warm. If the air conditioner cannot heat normally, it will have a certain impact on the user's health. For example, when the indoor air environment is seriously polluted, if the air conditioner cannot provide fresh air normally, it will also have a certain impact on the user's health. One thing that needs to be explained is that the current operating function here cannot be equated with the operating mode of the air conditioner, because the same operating mode can include multiple nonconflicting functions, for example, the cooling function and the fresh air function can both be performed in the cooling mode or the fresh air mode.

If it is identified that the current operating function of the air conditioner involves the personal safety function, it is necessary to determine the target memory frequency corresponding to the current interference value based on the determined current interference value. This is particularly important for accurate and reliable control of the air conditioner when personal safety is involved. According to the target memory frequency, the memory data in the wire controller can be stably accessed without being damaged, thereby improving the stability and safety of the wire controller's control over the air conditioner and avoiding serious impacts on the user's normal use and personal safety due to unstable memory data.

In an embodiment, the method for dynamically reducing the memory frequency further includes:
step g, if the current running function is the personal safety function, detecting whether a parameter setting operation is received;
step h, if the parameter setting operation is received, generating a prompt message that a preset safety mode needs to be entered; and
step i, when receiving a confirmation to enter the preset safety mode, determining the step of the target memory frequency corresponding to the current interference value according to the determined current interference value.

In an embodiment, if the current operating function is the personal safety function, it is also possible to detect whether a parameter setting operation is received, that is, to detect whether the user operates the wire controller. If the parameter setting operation is received, it is necessary to remind the user to enter a preset safety mode. The preset safety mode can be a mode that reduces the current memory frequency to a preset safety memory frequency. The preset safety memory frequency can be set according to actual needs. In short, the safety mode is to ensure the reliability of the air conditioner control to ensure the user's personal safety and user experience. When the user's confirmation to enter the preset safety mode is received, the target memory frequency corresponding to the current interference value is determined according to the determined current interference value, which will not be repeated here.

In an embodiment, after step S100, the method further includes:
if the current operating function is a non-personal safety function, determining the current memory frequency corresponding to the current compressor frequency of the air conditioner, and determining the target memory frequency corresponding to the current interference value based on the determined current interference value; and
selecting the lower memory frequency between the current memory frequency and the target memory frequency as the current memory frequency.

If the current operating function is the non-personnel safety function, the current memory frequency corresponding to the current compressor frequency can be determined. As for how to obtain the current memory frequency corresponding to the current compressor frequency, it can be determined by looking up a table or presetting a compressor frequency-memory frequency curve model. The current memory frequency belongs to the memory frequency that needs to be adjusted by default in the air-conditioning system when electromagnetic interference does not exist or is not considered. At the same time, according to the determined current interference value, the target memory frequency corresponding to the current interference value is determined. The target memory frequency is a memory frequency determined in order to resist electromagnetic interference while fully considering electromagnetic interference. The current memory frequency and the target memory frequency are compared and the lower memory frequency is determined as the current memory frequency. This enables the adjustment of the memory frequency to be more in line with the needs of the current working conditions and the current environment, and to a greater extent ensures the stability of the memory data and the stability, accuracy and reliability of the control of the air conditioner by the wire controller.

In an embodiment, after step S20, the method further includes:
configuring the target memory frequency as the target memory frequency of other air conditioner indoor units connected to the same outdoor unit.

Continuing to refer to FIG. 7, each air conditioner indoor unit has a corresponding wire controller. Therefore, only one wire controller is needed to determine the target memory frequency, and send the determined target memory frequency to the air conditioner outdoor unit. The air conditioner outdoor unit sends the determined target memory frequency to other wire controllers connected to the same air conditioner outdoor unit, and use it as the memory frequency of other air conditioners, which greatly saves the computing resources of the air conditioner and improves the efficiency of dynamic update of the target memory frequency.

In an embodiment, the method for dynamically reducing the memory frequency further includes:
sending, via the cloud or local area network, a memory frequency adjustment signal to other air conditioners, to enable the other air conditioners to perform each step of step S10-step S30.

As shown in FIG. 7, when the kit 1 interferes, the kit 2 can be notified through the cloud or local area network to perform the corresponding memory frequency adjustment. The adjustment steps are consistent with the above embodiments and will not be repeated here.

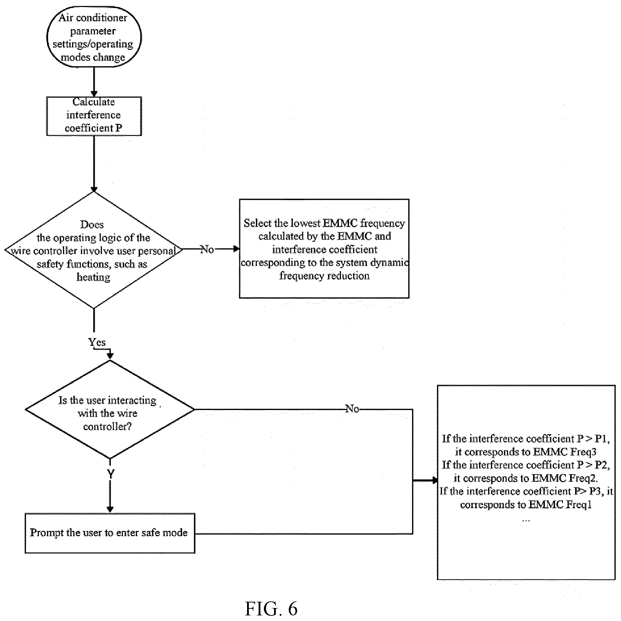

In order to further understand the implementation process of the above-mentioned embodiments, the above-mentioned embodiments can be combined as the technical solution of the present application as a whole. In order to understand the present application more clearly, please refer to FIG. 6, which is an overall application flow chart of the method for dynamically reducing the memory frequency according to an embodiment of the present application.

When the parameter setting or working mode of the air conditioner changes, calculating or looking up the table to determine the interference coefficient (interference level corresponding to the current interference value) P of the environment where the air conditioner is located;
determining whether the operation logic of the wire controller involves the user's life (personal) safety function, such as heating;
if the operation logic of the wire controller does not involve the user's personal safety function, selecting the minimum value of the EMMC frequency corresponding to the dynamic frequency reduction and the EMMC frequency calculated based on the interference coefficient (memory frequency corresponding to the compressor frequency);
if the operation logic of the wire controller involves the user's personal safety function, determining whether the user is interacting with the wire controller;
if the user is interacting with the wire controller, prompting the user to enter the safe mode, when the user determines to enter the safe mode, adjusting the memory frequency according to the following predetermined design;
if the user does not interact with the wire controller, the memory frequency is adjusted according to the predetermined design:
if the interference coefficient P>P1, the corresponding memory frequency is EMMC Freq3;
if the interference coefficient P>P2, the corresponding memory frequency is EMMC Freq2;
if the interference coefficient P>P3, the corresponding memory frequency is EMMC Freq1;

According to the degree of electromagnetic interference: P3>P2>P1, according to the size of the memory frequency: EMMC Freq3>EMMC Freq2>EMMC Freq1.

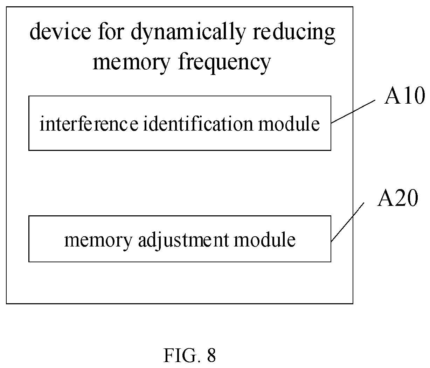

In addition, the present application also provides a device for dynamically reducing the memory frequency. Please refer to FIG. 8, the device for dynamically reducing the memory frequency includes an interference identification module A10 and a memory adjustment module A20.

The interference identification module A10 is configured to determine the current interference value of the air conditioner during the operation of the air conditioner.

The memory adjustment module A20 is configured to determine the target memory frequency corresponding to the current interference value according to the determined current interference value; and update the current memory frequency of the air conditioner according to the target memory frequency.

In an embodiment, the interference identification module A10 is also configured to:
obtain the current preset operating parameters during the operation of the air conditioner; and
according to the obtained preset operating parameters, calculate or look up the table to obtain the current interference value of the air conditioner.

In an embodiment, the interference identification module A10 is also configured to:
determine the current interference value of the air conditioner at a preset interval duration during the operation of the air conditioner; or
determine the current interference value of the air conditioner when a parameter setting operation is received or the working state of the air conditioner changes during the operation of the air conditioner.

In an embodiment, the memory adjustment module A20 is also configured to:
determine the target interference level of the current interference value according to the preset interference level; and
determine the target memory frequency corresponding to the target interference level.

In an embodiment, the memory adjustment module A20 is also configured to:
determine the current operating function of the air conditioner;
if the current operating function is a personal safety function, determine the step of the target memory frequency corresponding to the current interference value according to the determined current interference value.

In an embodiment, the memory adjustment module A20 is also configured to:
if the current operating function is a personal safety function, detect whether a parameter setting operation is received;
if the parameter setting operation is received, generate a prompt message that a preset safety mode needs to be entered; and
when receiving a confirmation to enter the preset safety mode, determine the step of the target memory frequency corresponding to the current interference value according to the determined current interference value.

In an embodiment, the memory adjustment module A20 is also configured to:
if the current operating function is a non-personal safety function, determine the current memory frequency corresponding to the current compressor frequency of the air conditioner, and determine the target memory frequency corresponding to the current interference value according to the determined current interference value; and
select the lower memory frequency between the current memory frequency and the target memory frequency as the current memory frequency.

In an embodiment, the memory adjustment module A20 is also configured to:
configuring the target memory frequency as the target memory frequency of other air conditioner indoor units connected to the same outdoor unit.

The specific implementation of the device for dynamically reducing the memory frequency of the present application is basically the same as the embodiments of the above-mentioned method for dynamically reducing the memory frequency, and will not be repeated here.

In addition, the present application also provides a computer-readable storage medium. A memory dynamic frequency reduction program is stored in the computer-readable storage medium of the present application. When the memory dynamic frequency reduction program is executed by the processor, the method for dynamically reducing the memory frequency described above is implemented.

The method implemented when the memory dynamic frequency reduction program is executed can refer to the various embodiments of the method for dynamically reducing the memory frequency of the present application, which will not be repeated here.

Those skilled in the art will appreciate that the embodiments of the present application can be provided as methods, systems, or computer program products. Therefore, the present application may take the form of a complete hardware embodiment, a complete software embodiment, or a combination of software and hardware embodiments. Moreover, the present application may take the form of a computer program product implemented on one or more computer-usable storage media (including but not limited to disk storage, CD-ROM, optical storage, etc.) containing computer-usable program codes.

The present application is described with reference to the flowcharts and/or block diagrams of the methods, devices (systems) and computer program products according to the embodiments of the present application. It should be understood that each process and/or box in the flowchart and/or block diagram, as well as the combination of the processes and/or boxes in the flowchart and/or block diagram, can be implemented by computer program instructions. These computer program instructions can be provided to a processor of a general-purpose computer, a special-purpose computer, an embedded processor or other programmable data processing device to generate a machine, so that the instructions executed by the processor of the computer or other programmable data processing device generate a device for implementing the functions specified in one process or multiple processes in the flowchart and/or one box or multiple boxes in the block diagram.

These computer program instructions may also be stored in a computer-readable memory that can direct a computer or other programmable data processing device to work in a specific manner, so that the instructions stored in the computer-readable memory produce a manufactured product including an instruction device that implements the functions specified in one or more processes in the flowchart and/or one or more boxes in the block diagram.

These computer program instructions may also be loaded onto a computer or other programmable data processing device so that a series of operational steps are executed on the computer or other programmable device to produce a computer-implemented process, whereby the instructions executed on the computer or other programmable device provide steps for implementing the functions specified in one process or multiple processes in the flowchart and/or one box or multiple boxes in the block diagram.

It should be noted that in the claims, any reference signs placed between brackets shall not be construed as limiting the claims. The word "comprising" does not exclude the presence of components or steps not listed in the claims. The word "a" or "an" preceding a component does not exclude the presence of a plurality of such components. The present application may be implemented by means of hardware including several different components and by means of a suitably programmed computer. In a unit claim enumerating several means, several of these means may be embodied by the same item of hardware. The use of the words first, second, and third etc. does not indicate any order. These words may be interpreted as names.

Although the preferred embodiments of the present application have been described, those skilled in the art may make additional changes and modifications to these embodiments once they know the basic creative concepts. Therefore, the attached claims are intended to be interpreted as including the preferred embodiments and all changes and modifications that fall within the scope of the present application.

The above are only some embodiments of the present application, and does not limit the scope of the present application. All equivalent structural changes made by using the contents of the description and drawings of the present application under the inventive concept of the present application, or directly/indirectly applied in other related technical fields, are included in the scope of the present application.

## Claims

1. A method for dynamically reducing a memory frequency for an air conditioner, **characterized by** comprising:
determining a current interference value of the air conditioner during an operation of the air conditioner;
determining a target memory frequency corresponding to the current interference value according to the determined current interference value; and
updating a current memory frequency of the air conditioner according to the target memory frequency.

2. The method for dynamically reducing the memory frequency according to claim 1, wherein the determining the current interference value of the air conditioner during the operation of the air conditioner comprises:
obtaining a current preset operating parameter during the operation of the air conditioner; and
calculating or looking up a table to obtain the current interference value of the air conditioner according to the obtained preset operating parameter.

3. The method for dynamically reducing the memory frequency according to claim 1, wherein the determining the current interference value of the air conditioner during the operation of the air conditioner comprises:
determining the current interference value of the air conditioner at a preset interval duration during the operation of the air conditioner; or
determining the current interference value of the air conditioner in response to that a parameter setting operation is received or a working state of the air conditioner changes during the operation of the air conditioner.

4. The method for dynamically reducing the memory frequency according to claim 1, wherein the determining the target memory frequency corresponding to the current interference value according to the determined current interference value comprises:
determining a target interference level of the current interference value according to a preset interference level; and
determining the target memory frequency corresponding to the target interference level.

5. The method for dynamically reducing the memory frequency according to claim 1, further comprising:
determining a current operating function of the air conditioner; and
in response to that the current operating function is a personal safety function, determining a step of the target memory frequency corresponding to the current interference value according to the determined current interference value.

6. The method for dynamically reducing the memory frequency according to claim 5, further comprising:
in response to that the current operating function is the personal safety function, detecting whether a parameter setting operation is received;
in response to that the parameter setting operation is received, generating a prompt to enter a preset safety mode; and
in response to receiving a confirmation to enter the preset safety mode, determining the step of the target memory frequency corresponding to the current interference value according to the determined current interference value.

7. The method for dynamically reducing the memory frequency according to claim 5, wherein after the determining the current operating function of the air conditioner, the method further comprises:
in response to the current operating function is a non-personnel safety function, determining the current memory frequency corresponding to a current compressor frequency of the air conditioner, and determining the target memory frequency corresponding to the current interference value according to the determined current interference value; and
selecting a lower memory frequency between the current memory frequency and the target memory frequency as the current memory frequency.

8. The method for dynamically reducing the memory frequency according to claim 1, wherein after the determining the target memory frequency corresponding to the current interference value according to the determined current interference value, the method further comprises:
configuring the target memory frequency as a target memory frequency of other air conditioner indoor units connected to a same outdoor unit.

9. An air conditioner, **characterized by** comprising a processor, a memory, and a program for dynamically reducing a memory frequency stored in the memory and executable by the processor, wherein when the program for dynamically reducing the memory frequency is executed by the processor, a method for dynamically reducing the memory frequency according to any one of claims 1 to 8 is implemented.

10. A computer-readable storage medium, wherein a program for dynamically reducing a memory frequency is stored on the computer-readable storage medium, when the program for dynamically reducing the memory frequency is executed by a processor, a method for dynamically reducing the memory frequency according to any one of claims 1 to 8 is implemented.
